# EUROPÄISCHE PATENTANMELDUNG

(11) **EP 1 312 934 A2**
(43) Veröffentlichungstag der Anmeldung: **21.05.2003**
(21) Anmeldenummer: 02023614.7
(22) Anmeldetag: 17.10.2002
(51) Int. Cl.: G01R 33/02

(54) **Magnetometersonde**

(30) Priorität: 15.11.2001 DE 20118655 U
(71) Anmelder: FIRMA ING. KLAUS EBINGER, D-51149 Köln (DE)
(72) Erfinder: Ebinger, Klaus, 51149 Köln (DE)
(74) Vertreter: Heim, Hans-Karl, Dipl.-Ing.

(57) **Zusammenfassung**

Die Erfindung betrifft eine Magnetometersonde (10) mit einem rohrförmigen Sondengehäuse (12) und zwei im Wesentlichen koaxial zur Längsachse des Sondengehäuses in diesem voneinander beabstandet angeordneten Induktoren (14,16), wobei zumindest einer der Induktoren bezüglich der Längsachse des Sondengehäuses in diesem schwenkbar gelagert und in seiner Schwenkposition arretierbar ist. Um die Parallelisierung der Messstreifen der Induktoren mit sehr hoher Genauigkeit zu ermöglichen, wird der schwenkbare Induktor durch eine elastische Lagerung (20,22) um zwei rechtwinklig zur Längsachse des Sondengehäuses und rechtwinklig zueinander verlaufende Richtungen schwenkbar gelagert.

## Beschreibung

Die Erfindung betrifft eine Magnetometersonde nach dem Oberbegriff des Anspruchs 1.

Eine Magnetometersonde der eingangs genannten Art ist aus EP 0 590 349 B1 bekannt und wird unter anderem zum Suchen und Orten von Objekten im Erdboden, die das natürliche Magnetfeld beeinflussen, oder auch für geophysikalische Magnetfeldvermessungen eingesetzt. Insbesondere zum Suchen und Orten von das Magnetfeld beeinflussenden Objekten haben sich sogenannte Saturationsmagnetometer in der Art eines Feldstärke-Differenzmessers durchgesetzt.

Dieser Typ Magnetometersonde ist mit zwei magnetempfindlichen Induktoren ausgestattet, wobei jeder Induktor mit einem durch eine Erregerwicklung umgebenen Messstreifen ausgestattet ist. Die Induktoren sind in einem vorgegebenen Basisabstand voneinander koaxial in einem rohrförmigen Sondengehäuse aufgenommen. Beide Induktoren sind in Differenz so geschaltet, dass das magnetische Feld der Erde weitgehend kompensiert wird. Ein in der Nähe der Magnetometersonde befindliches Objekt, das das natürliche magnetische Erdfeld stört bzw. ein Eigenfeld besitzt, welches das magnetische Erdfeld überlagert, führt aufgrund des räumlichen Abstandes der Induktoren zu einem elektrischen Differenzsignal, das von der Magnetometersonde ausgegeben wird.

Derartige Magnetometersonden sind sehr empfindlich; sie lösen etwa den einhunderttausendsten Teil der Totalintensität des Erdfeldes auf und sind damit in der Lage, Differenzfeldstärken im Nanotesla-Bereich nachzuweisen. Wesentliche Voraussetzung für das Erreichen einer derartig hohen Empfindlichkeit sind die sogenannte mechanische Parallelisierung der Messstreifen sowie der elektrische Abgleich der Induktoren.

So müssen die Messstreifen der beiden Induktoren mit möglichst großer Genauigkeit parallel zueinander ausgerichtet sein, da schon geringste Lageabweichungen zwischen diesen das Messsignal beeinflussen. Um eine außerordentlich hohe Empfindlichkeit zu erzielen, dürfen die Messstreifen der Induktoren in ihrer Lage etwa in einem Bereich von 1/100 Grad abweichen, damit die vom magnetischen Feld der Erde ausgeübten Induktionen auf den jeweiligen Induktor um den gleichen Betrag entgegengesetzt gleich sind.

Aus der DE 25 25 751 B1 ist eine Magnetometersonde bekannt, bei der die beiden Induktoren jeweils mit einer Verstelleinrichtung versehen sind, die eine Verschwenkung der beiden Induktoren relativ zum Magnetometergehäuse um zueinander rechtwinklig verlaufende Querachsen des Magnetometergehäuses gestatten, um die Messstreifen zu parallelisieren. Bei dieser bekannten Magnetometersonde sind zwei Verstelleinrichtungen für eine Parallelisierung der Messstreifen der Induktoren notwendig, wobei jede Verstelleinrichtung einen aufwendigen Aufbau aufweist.

Aus der gattungsbildenden EP 0 590 349 B1 ist eine Magnetometersonde bekannt, bei der nur eine der beiden Induktoren in einer quer zur Längsachse des Sondengehäuses verlaufenden Richtung schwenkbar gelagert und in seiner Schwenkposition arretierbar ist, um die Messstreifen zu parallelisieren. Damit die beiden Induktoren zueinander ausgerichtet werden können, sind die beiden Induktoren unabhängig voneinander um die Längsachse des Sondengehäuses drehbar gelagert.

Ausgehend von diesem Stand der Technik ist es **Aufgabe** der Erfindung, eine Magnetometersonde anzugeben, die sich durch einen einfachen Aufbau auszeichnet und gleichzeitig eine Parallelisierung der Messstreifen der Induktoren mit sehr hoher Genauigkeit ermöglicht.

Die Erfindung löst die Aufgabe durch eine Magnetometersonde mit den Merkmalen nach Anspruch 1.

Bei der erfindungsgemäßen Magnetometersonde ist der schwenkbare Induktor durch eine elastische Lagerung im Sondengehäuse schwenkbar gelagert. Die elastische Lagerung ist dabei so ausgelegt, dass der schwenkbare Induktor um zwei rechtwinklig zur Längsachse des Sondengehäuses und rechtwinklig zueinander verlaufenden Richtungen schwenkbar ist. Der schwenkbare Induktor kann also bezüglich des zweiten Induktors mit seinem zu parallelisierenden Messstreifen in einer von den beiden rechtwinklig verlaufenden Richtungen definierten Ebene stufenlos verstellt werden. Auf diese Weise ist eine zusätzliche Beweglichkeit des zweiten Induktors nicht zwangsweise erforderlich, so dass sich der Aufbau der Magnetometersonde insgesamt vereinfacht. Darüber hinaus ist die Gestaltung der Magnetometersonde verglichen mit den bekannten Magnetometersonden vereinfacht, da der Induktor lediglich durch die elastische Lagerung im Sondengehäuse gelagert ist, ohne dass zusätzliche Lagerelemente zwangsweise erforderlich sind. Ferner ermöglicht die elastische Lagerung eine sehr genaue Einstellung des schwenkbaren Induktors, da bei dessen Arretierung in der eingestellten Schwenkposition der schwenkbare Induktor durch die Arretierung in der gewünschten Schwenkposition gehalten ist und der schwenkbare Induktor gegenüber von außen einwirkenden Erschütterungen durch die elastische Lagerung gedämpft ist.

Weitere vorteilhafte Weiterbildungen der Erfindung ergeben sich aus der nachfolgenden Beschreibung, der Zeichnung sowie den Unteranprüchen.

So wird bei einer bevorzugten Ausführungsform der Magnetometersonde vorgeschlagen, den schwenkbaren Induktor in einem Induktorhalter aufzunehmen, mit dem der schwenkbare Induktor in der elastischen Lagerung gelagert ist. Durch Verwendung des Induktorhalters werden verschiedene Vorteile erreicht. Einerseits ist der vergleichsweise empfindliche Induktor sowohl bei der Montage als auch beim Justieren insbesondere vor mechanischen Beschädigungen durch den Induktorhalter geschützt. Andererseits kann der Induktorhalter optimal an die Gestaltungsvorgaben der elastischen Lagerung angepasst werden kann.

Die elastische Lagerung ist vorzugsweise aus mindestens zwei axial voneinander beabstandeten elastischen Elementen gebildet, die den schwenkbaren Induktor oder den Induktorhalter im Sondengehäuse schwenkbar lagern. Durch den axialen Abstand zwischen den elastischen Elementen wirkt das elastische Element, nahe dem der Induktor bzw. der Induktorhalter in der eingestellten Schwenkposition arretiert wird, als Vorspannelement, das durch die Verschwenkung des Induktors bzw. Induktorhalters elastisch verformbar ist und auf diese Weise den Induktor bzw. den Induktorhalter im Sondengehäuse in der gewünschten Schwenkposition mechanisch vorspannt. Das von diesem beabstandete zweite elastische Element dient dagegen als Schwenklagerstelle. Als elastische Elemente werden insbesondere Ringe aus einem elastischen Material eingesetzt, da durch die Ringgestalt der elastischen Elemente die gewünschte Verstellbarkeit in die beiden rechtwinklig zueinander verlaufenden Richtungen auf einfache Weise realisiert werden kann. Insbesondere werden hierzu O-Ringe eingesetzt, die sich durch einen im Wesentlichen kreisrunden Querschnitt auszeichnen, da sich diese besonders gleichmäßig an Oberflächen anlegen.

Bei Verwendung derartiger elastischer O-Ringe wird bei einer bevorzugten Ausführungsform vorgeschlagen, die beiden O-Ringe entweder direkt auf den Induktor oder aber bei Verwendung eines Induktorhalters, auf den Induktorhalter aufzuschieben. Der mit den beiden elastischen Ringen versehenen Induktor bzw. Induktorhalter ist nach seiner Montage so im Sondengehäuse aufgenommen, dass die beiden elastischen Ringe unter Vorspannung an der Innenwand des Sondengehäuses anliegen und den Induktor oder den Induktorhalter mit Abstand zu Innenwand des Sondengehäuses in diesem halten. Durch diese Art der Anordnung der beiden elastischen Ringe ist auf sehr einfache und elegante Weise eine äußerst exakte Positionierung des Induktors bzw. des Induktorhalters im Sondengehäuse möglich, wobei eventuelle Maßabweichungen an den Oberflächen, an denen die elastischen Ringe anliegen, durch die elastische Verformbarkeit der elastischen Ringe ausgeglichen werden. Gleichzeitig wird der Induktor bzw. der Induktorhalter durch die Elastizität der elastischen Ringe beim Einsetzen konzentrisch mit Abstand zur Innenwand im Sondengehäuse gehalten.

Um eine möglichst exakte Positionierung der elastischen Ringe bezüglich des Induktors zu erreichen wird bei dieser Ausführungsform ferner vorgeschlagen, jeden elastischen Ring in einer am Induktor bzw. am Induktorhalter vorgesehene Nut aufzunehmen.

Bei einer weiteren bevorzugten Ausführungsform der erfindungsgemäßen Magnetometersonde wird vorgeschlagen, am Sondengehäuse eine Justiervorrichtung vorzusehen, welche den schwenkbaren Induktor oder den Induktorhalter in seiner eingestellten Schwenkposition hält. Mit Hilfe der Justiervorrichtung wird die Schwenkposition des schwenkbaren Induktors bezüglich des zweiten Induktors justiert, wobei die Justiervorrichtung gleichzeitig den schwenkbaren Induktor bzw. den Induktorhalter in der justierten Schwenkposition sichert bzw. arretiert.

Die Justiervorrichtung weist vorzugsweise einen konzentrisch zur Längsachse angeordneten Justierring auf, der am Sondengehäuse befestigt ist und durch den der Induktor oder der Induktorhalter teilweise ragt. Gleichmäßig über den Umfang des Justierrings verteilt sind mindestens drei bezüglich der Längsachse des Sondengehäuses radial verstellbare Stellelemente vorgesehen, die den schwenkbaren Induktor oder den schwenkbaren Induktorhalter in der eingestellten Schwenkposition bezüglich der Längsachse halten. Durch Einstellen der drei gleichmäßig über den Umfang des Justierrings verteilten Stellelemente kann der schwenkbare Induktor mit seinem auszurichtenden Abschnitt innerhalb der von den beiden rechtwinklig zu Längsachse verlaufenden Richtungen definierten Ebene in jede gewünschte Schwenkposition auf einfache Weise verstellt werden, um die Messstreifen zu parallelisieren, wobei die Stellelemente den schwenkbaren Induktor in der gewünschten Schwenkposition definiert halten. Als Stellelemente werden insbesondere Stellschrauben verwendet, die in am Justierring entsprechend ausgebildete Durchgangsgewinde eingeschraubt sind.

Der Justierring ist vorzugsweise an dem Ende des Sondengehäuses befestigt, an dem der schwenkbare Induktor vorgesehen ist, wobei die elastische Lagerung unmittelbar benachbart zum Justierring im Sondengehäuse angeordnet ist. Durch diese Art der Anordnung des Justierrings gemeinsam mit der elastischen Lagerung wird ein besonders kompakter Aufbau der Magnetometersonde erreicht, so dass die zum Halten des schwenkbaren Induktors in der gewünschten Schwenkposition erforderlichen Haltekräfte aufgrund des geringen Abstandes der elastischen Lagerung zum Justierring gleichfalls gering sind.

Um die Parallelisierung der Messstreifen der beiden Induktoren zueinander ferner zu erleichtern, wird darüber hinaus vorgeschlagen, zumindest einen der beiden Induktoren um die Längsachse des Sondengehäuses verdrehbar anzuordnen.

Des Weiteren wird bei einer bevorzugten Ausführungsform der Magnetometersonde für den zweiten Induktor ein Induktorhalter vorgesehen, in dem der zweite Induktor aufgenommen und durch den der zweite Induktor im Sondengehäuse gehalten ist. Auch durch die Verwendung dieses zweiten Induktorhalters ergeben sich die zuvor geschilderten Vorteile, dass der zweite Induktor insbesondere gegenüber äußeren mechanischen Einwirkungen gut geschützt ist.

Besonders bevorzugt ist es, den Induktor bzw. die Induktoren jeweils durch elastische Elemente, welche auf den jeweiligen Induktor aufgeschoben sind, in dem dem jeweiligen Induktor zugeordneten Induktorhalter zu halten. Durch diese elastischen Elemente, beispielsweise elastische Ringe, wird erreicht, dass der Induktor präzise im Induktorhalter gehalten ist, wobei eventuelle Maßabweichungen am Induktor oder am Induktorhalter durch die elastischen Elemente auf einfache Weise ausgeglichen werden. Darüber hinaus wird vorgeschlagen, auch den zweiten Induktorhalter, sofern dieser vorgesehen ist, durch elastische Elemente im Sondengehäuse zu halten, so dass auch der zweite Induktorhalter des zweiten Induktors in entsprechender Weise präzise im Sondengehäuse positioniert ist.

In einer besonders bevorzugten Weiterbildung der erfindungsgemäßen Magnetometersonde wird auch der zweite Induktor entsprechend dem schwenkbaren ersten Induktor durch eine elastische Lagerung im Sondengehäuse schwenkbar gelagert, wobei auch der zweite Induktor in seiner eingestellten Schwenkposition arretierbar ist. Bei dieser Ausführungsform sind also beide Induktoren sowohl relativ zueinander als auch relativ zum Sondengehäuse schwenkbar, so dass auch größere Lagerabweichungen zwischen den Messstreifen der beiden Induktoren ohne großen Aufwand ausgeglichen und die beiden Messstreifen der Induktoren zueinander parallel ausgerichtet werden können.

Die elastische Lagerung des zweiten Induktors ist dabei vorzugsweise so ausgebildet, wie die elastische Lagerung des ersten schwenkbaren Induktors. Gleiches gilt auch für die gegebenenfalls zusätzlich vorgesehene Justiervorrichtung des zweiten Induktors, die ebenfalls in entsprechender Weise zu der Justiervorrichtung des ersten schwenkbaren Induktors gestaltet ist. Durch die Verwendung sowohl identischer elastischer Lagerungen als auch identischer Justiervorrichtungen für beide Induktoren ist sowohl die Fertigung als auch die Montage der erfindungsgemäßen Magnetometersonde aufgrund der geringen Teilevielfalt vereinfacht.

Damit die Magnetometersonde auch für den Unterwassereinsatz geeignet ist, wird ferner vorgeschlagen, das Sondengehäuse nach außen hin fluiddicht abgedichtet zu gestalten.

Bei einer bevorzugten Ausführungsform der Magnetometersonde wird hierzu vorgeschlagen, zum Abdichten des Sondengehäuses an diesen Verschlusskappen vorzusehen, die die beiden offenen Enden, in die die Induktoren eingesetzt sind, verschließen.

Nachfolgend wird die Erfindung anhand eines Ausführungsbeispieles unter Bezugnahme auf die Zeichnung näher erläutert. Darin zeigen:
- Fig. 1: eine Seitenansicht einer erfindungsgemäßen Magnetometersonde;
- Fig. 2: eine Schnittansicht in Längsrichtung der Magnetometersonde nach Fig. 1;
- Fig. 3: eine Schnittansicht entlang der Schnittlinie A-A in Fig. 2 durch die erfindungsgemäße Magnetometersonde und
- Fig. 4: einen Ausschnitt der in Fig. 2 gezeigten Schnittansicht der erfindungsgemäßen Magnetometersonde mit aufgeschraubter Verschlusskappe.

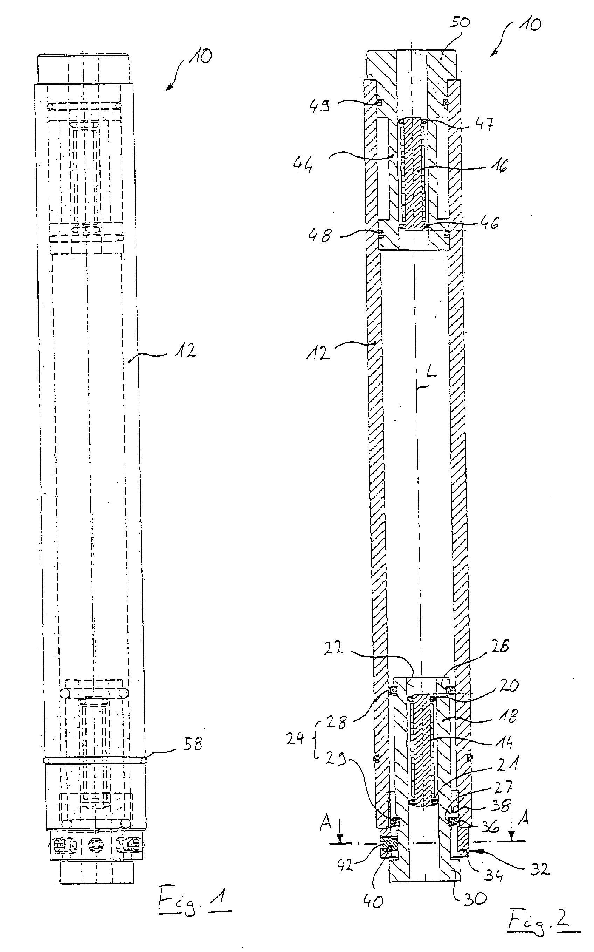

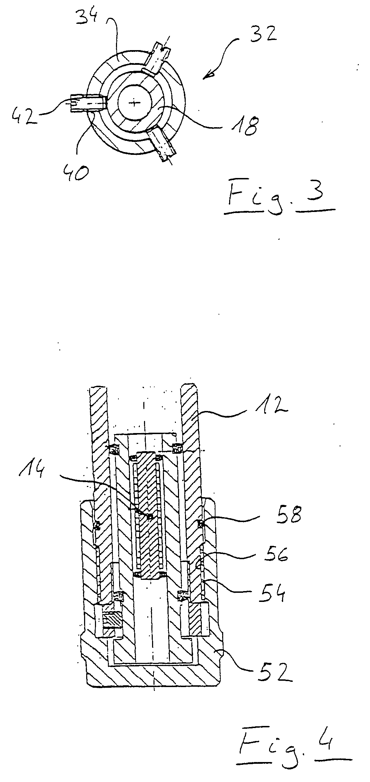

In den Fig. 1 und 2 ist eine Magnetometersonde 10 dargestellt, mit der Objekte, die das magnetische Erdfeld beeinflussen oder die selbst ein Magnetfeld erzeugen, geortet werden können. Die Sonde 10 weist ein Sondengehäuse 12 auf, in dem zwei Induktoren 14 und 16 aufgenommen sind. Die beiden Induktoren 14 und 16 sind in Längsrichtung L des Sondengehäuses 12 betrachtet axial voneinander beabstandet. In jedem Induktor 14 und 16 ist ein Messstreifen (nicht dargestellt) aufgenommen, der von einer nicht dargestellten Erregerwicklung umgeben ist.

Der in der Schnittansicht in Fig. 2 am unteren Ende des Sondengehäuses 12 dargestellte Induktor 14 ist schwenkbar ausgebildet. Zu diesem Zweck ist der Induktor 14 in einem schwenkbaren Induktorhalter 18 aufgenommen. Gehalten wird der schwenkbare Induktor 14 durch zwei axial zueinander beabstandete elastische Halteringe 20 und 21, mit denen er konzentrisch in einer im Induktorhalter 18 ausgebildeten Haltebohrung 22 gehalten ist. Die Halteringe 20 und 21 liegen dabei mit so großer Vorspannung an der Innenwand der Haltebohrung 22 an, dass der Induktor 14 in der gewünschten Position im Induktorhalter 18 gesichert ist. Alternativ kann der Induktor 14 auch durch Vergießen, beispielsweise mit Kunstharz, im Induktorhalter 18 gehalten sein.

Der schwenkbare Induktorhalter 18 ist durch eine elastische Lagerung 24 schwenkbar im Sondengehäuse 12 gelagert. Zu diesem Zweck sind am Außenumfang des im Wesentlichen hohlzylindrisch ausgebildeten Induktorhalters 18 zwei voneinander beabstandete umlaufende Nuten 26 und 27 ausgebildet.
In der Nut 26 bzw. 27 ist jeweils ein O-Ring 28 bzw. 29 aus einem elastischen Material aufgenommen.

Der Induktorhalter 18 wird durch die elastische Lagerung 24 im offenen Ende des Sondengehäuses 12 gehalten, wobei die beiden O-Ringe 28 und 29 den Induktorhalter 18 gemeinsam mit dem Induktor 14 gleichfalls im Wesentlichen koaxial zur Längsachse L des Sondengehäuses 12 halten. Des Weiteren ist an dem aus dem Sondengehäuse 12 ragenden Ende des Induktorhalters 18 ein radial abstehender Bund 30 ausgebildet, dessen Zweck später noch erläutert wird.

Der schwenkbare Induktorhalter 18 ragt durch eine Justiervorrichtung 32, die an dem in Fig. 2 unten dargestellten Ende des Sondengehäuses 12 vorgesehen ist. Die Justiervorrichtung 32 weist einen Justierring 34 auf, der im Wesentlichen koaxial zur Längsachse L des Sondengehäuses 12 positioniert ist. In axialer Richtung steht vom Justierring 34 ein Gewindebund 36 ab, mit dem der Justierring 34 in ein am Sondengehäuse 12 vorgesehenes Innengewinde 38 eingeschraubt ist. Alternativ kann der Gewindebund 36 als glatter Bund ausgebildet sein, mit dem der Justierring 34 im Sondengehäuse 12 durch Vergießen, beispielsweise mit Kunstharz, gesichert ist.

Wie insbesondere Fig. 3 zeigt, in dem der Schnitt A-A von Fig. 2 dargestellt ist, sind am Justierring 34 insgesamt drei über dessen Umfang gleichmäßig verteilte Gewindebohrungen 40 ausgebildet. In jede Gewindebohrung 40 ist jeweils eine Stellschraube 42 eingeschraubt, die mit ihrer Längsachse radial bezüglich der Längsachse L des Sondengehäuses 12 verläuft. Die als Madenschrauben ausgebildeten Stellschrauben 42 liegen mit ihren Stirnseiten am schwenkbaren Induktorhalter 18 an, und halten diesen in einer gewünschten Stellung, wie später noch erläutert wird.

Der zweite Induktor 16 ist in identischer Weise, wie der erste Induktor 14 in einem zweiten Induktorhalter 44 durch Halterringe 46 und 47 gehalten. Auch der zweite Induktor kann alternativ durch Vergießen, beispielsweise mit Kunstharz, im zweiten Induktorhalter 44 gesichert sein.

Der zweite Induktorhalter 44 entspricht in seiner Gestalt im Wesentlichen dem schwenkbaren Induktorhalter 18. Allerdings ist der Außendurchmesser des in das Sondengehäuse 12 eingeführten Abschnittes des zweiten Induktorhalters 44 größer bemessen als der des ersten Induktorhalters 18, kann jedoch in seinen Abmessungen auch identisch zum ersten Induktorhalter 18 ausgebildet sein. Auch der zweite Induktorhalter 44 ist durch zweite O-Ringe 48 und 49 im Sondengehäuse 12 definiert gehalten, wobei der zweite Induktorhalter 44 mit seinem in das Sondengehäuse 12 eingeführten Ende an einem im Sondengehäuse 12 ausgebildeten Bund 50 anliegt.

Auch bei dem zweiten Induktorhalter 44 wird durch die Verwendung der Halterringe 46 und 47 und der beiden O-Ringe 48 und 49 erreicht, dass der zweite Induktor 16 bezüglich der Längsachse L im Wesentlichen koaxial präzise im Sondengehäuse 12 gehalten ist.

Durch diese Art der Befestigung der beiden Induktoren 14 und 16 im Sondengehäuse 12 wird bereits bei der Montage der beiden Induktoren 14 und 16 ein so hohes Maß an Vorparallelität zwischen den Messstreifen der Induktoren 14 und 16 erzielt, dass lediglich kleine Kipp- bzw. Schwenkbewegung des Induktors 14 durch den Induktorhalter 18 ausreichen, um die gewünschte Parallelisierung des Messstreifens herbeizuführen, wie nachfolgend erläutert wird.

So müssen die beiden Induktoren 14 und 16 einerseits in einem vorgegebenen Basisabstand im Sondengehäuse 12 angeordnet sein. Dabei erleichtert der Bund 50 die Drehung des zweiten Induktors 16 um die Längsachse L des Sondengehäuses 12, dessen Induktorhalter 44 nach der Montage mit dem Bund 50 an der Stirnseite des Sondengehäuses 12 anliegt. Durch entsprechendens axiales Hin- und Herbewegen des Induktorhalters 18 relativ zum Sondengehäuse 12 kann dann der schwenkbare erste Induktor 14 relativ zum zweiten Induktor 16 axial eingestellt werden.

Anschließend muss eine einerseits eine mechanische Parallelisierung der Messstreifen und andererseits ein sogenannter "Schaukelabgleich" durchgeführt werden.

Bei der mechanischen Parallelisierung wird die räumliche Lage der Messstreifen der beiden Induktoren 14 und 16 so ausgerichtet, dass die vom Erdfeld in den Induktoren 14 und 16 induzierten Spannungen entgegengesetzt gleich sind. Der vollständige Schaukelabgleich erfolgt dann üblicherweise durch elektrische Symmetrierung der beiden Induktorwicklungen.

Zur mechanischen Parallelisierung der Messstreifen werden zunächst die beiden Induktoren 14 und 16 relativ zueinander und bezüglich des Sondengehäuses 12 um die Längsachse L des Sondengehäuses 12 verdreht. Anschließend kann durch Verstellen der verschiedenen Stellschrauben 42 der Justiervorrichtung 32 der schwenkbare Induktorhalter 18 in der elastischen Lagerung 24 hin- und herbewegt werden. Dabei dient der O-Ring 29 nahe der Justiervorrichtung 32 als federndes Element, das den notwendigen Gegendruck zur Fixierung der drei Stellschrauben 42 erzeugt, während der axial beabstandet von diesem angeordnete O-Ring 28 als Schwenklagerstelle wirkt.

Der Abgleich der beiden Induktoren 14 und 16 erfolgt durch wechselseitiges Drehen der Induktoren 14 und 16 sowie durch Kippen bzw. Schwenken des schwenkbaren Induktors 14. Auf diese Weise kann der schwenkbare Induktor 14 und damit dessen Messstreifen in zwei rechtwinklig zueinander verlaufende Richtungen X und Y, die gleichzeitig rechtwinklig zur Längsachse L des Sondengehäuses 12 verlaufen, stufenlos verschwenkt werden.

Nach der Parallelisierung der Messstreifen der beiden Induktoren 14 und 16 wird der zuvor angesprochene Schaukelabgleich mit der nicht dargestellten elektronischen Sondensteuerung vorgenommen.

Damit die Sonde 10 gegebenenfalls auch unter Wasser eingesetzt werden kann, können die Enden der Sonde 10 durch Verschlusskappen 52 verschlossen werden. In Fig. 4 ist eine derartige Verschlusskappe 52 im Schnitt dargestellt, die an dem Ende des Sondengehäuses 12 befestigt ist, in das der schwenkbare Induktor 14 eingeführt ist. Zum lösbaren Befestigen der Verschlusskappe 52 ist ein Innengewinde 54 vorgesehen, mit dem die Verschlussklappe 52 auf ein am Sondengehäuse 12 vorgesehenes Außengewinde 56 aufgeschraubt ist.

Eine zusätzliche auf das Sondengehäuse 12 aufgeschobene Dichtung 58, kommt dabei mit der Innenseite der Verschlusskappe 52 abdichtend in Berührung, so dass Feuchtigkeit und Wasser nicht von außen in das Sondengehäuse 12 eindringen können.

Bei der zuvor beschriebenen Sonde 10 sind die Induktoren 14 und 16 durch Induktorhalter 18 und 44 im Sondengehäuse 12 gehalten. Bei entsprechender Gestaltung der Induktoren 14 und 16 ist es jedoch auch möglich, auf die Verwendung derartige Induktorhalter 18 und 44 zu verzichten. Des Weiteren ist es möglich, beide Induktoren 14 und 16 in der zuvor beschriebenen Weise schwenkbar zu gestalten, so dass für beide Induktoren 14 und 16 jeweils eine Justiervorrichtung 32 am Sondengehäuse 12 befestigt ist.

## Patentansprüche

1. Magnetometersonde mit einem rohrförmigen Sondengehäuse (12) und zwei im Wesentlichen koaxial zur Längsachse (L) des Sondengehäuses (12) in diesem voneinander beabstandet angeordneten Induktoren (14, 16), wobei zumindest einer der Induktoren (14) bezüglich der Längsachse (L) des Sondengehäuses (12) in diesem schwenkbar gelagert und in seiner Schwenkposition arretierbar ist,
**dadurch gekennzeichnet,**
**dass** der schwenkbare Induktor (14) durch eine elastische Lagerung (24) um zwei rechtwinklig zur Längsachse (L) des Sondengehäuses (12) und rechtwinklig zueinander verlaufende Richtungen (X, Y) schwenkbar gelagert ist.

2. Magnetometersonde nach Anspruch 1,
**dadurch gekennzeichnet,**
**dass** der schwenkbare Induktor (14) in einem Induktorhalter (18) aufgenommen ist, mit dem der schwenkbare Induktor (14) in der elastischen Lagerung (24) gelagert ist.

3. Magnetometersonde nach Anspruch 1 oder 2,
**dadurch gekennzeichnet,**
**dass** die elastische Lagerung (24) aus mindestens zwei axial voneinander beabstandeten elastischen Elementen (28, 29) gebildet ist, die den schwenkbaren Induktor (14) oder den Induktorhalter (18) im Sondengehäuse (12) schwenkbar lagern.

4. Magnetometersonde nach Anspruch 3,
dass die beiden elastischen Elemente zwei Ringe (28, 29) aus einem elastischen Material, insbesondere O-Ringe sind.

5. Magnetometersonde nach Anspruch 4,
**dadurch gekennzeichnet,**
**dass** die beiden elastischen Ringe (28, 29) auf den Induktor (14) oder auf den Induktorhalter (18) aufgeschoben sind, unter Vorspannung an der Innenwand des Sondengehäuses (12) anliegen und den Induktor (14) oder den Induktorhalter (18) mit Abstand zur Innenwand des Sondengehäuses (12) in diesem halten.

6. Magnetometersonde nach Anspruch 4 oder 5,
**dadurch gekennzeichnet,**
**dass** jeder elastische Ring (28, 29) in einer Nut (26, 27) am Induktor (14) oder am Induktorhalter (18) aufgenommen ist.

7. Magnetometersonde nach einem der vorhergehenden Ansprüche,
**dadurch gekennzeichnet,**
**dass** am Sondengehäuse (12) eine Justiervorrichtung (32) vorgesehen ist, welche den schwenkbaren Induktor (14) oder den Induktorhalter (18) in seiner eingestellten Schwenkposition hält.

8. Magnetometersonde nach Anspruch 7,
**dadurch gekennzeichnet,**
- **dass** die Justiervorrichtung (32) einen konzentrisch zur Längsachse (L) angeordneten Justierring (34) aufweist, der am Sondengehäuse (12) befestigt ist und durch den der Induktor (14) oder der Induktorhalter (18) teilweise ragt, und
- **dass** gleichmäßig über den Umfang des Justierrings (34) verteilt mindestens drei bezüglich der Längsachse (L) des Sondengehäuses (12) radial verstellbare Stellelemente, insbesondere drei Stellschrauben (42), vorgesehen sind, die den schwenkbaren Induktor (14) oder den schwenkbaren Induktorhalter (18) in der eingestellten Schwenkposition bezüglich der Längsachse (L) halten.

9. Magnetometersonde nach Anspruch 8,
**dadurch gekennzeichnet,**
- **dass** der Justierring (34) an dem Ende des Sondengehäuses (12), an dem der schwenkbare Induktor (14) vorgesehen ist, befestigt ist und
- **dass** die elastische Lagerung (24) unmittelbar benachbart zum Justierring (34) im Sondengehäuse (12) angeordnet ist.

10. Magnetometersonde nach einem der vorhergehenden Ansprüche,
**dadurch gekennzeichnet,**
**dass** der schwenkbare Induktor (14) und/oder der zweite Induktor (16) um die Längsachse (L) des Sondengehäuses (12) verdrehbar sind bzw. ist.

11. Magnetometersonde nach einem der vorhergehenden Ansprüche,
**dadurch gekennzeichnet,**
**dass** der zweite Induktor (16) in einem zweiten Induktorhalter (44) aufgenommen und durch diesen im Sondengehäuse (12) gehalten ist.

12. Magnetometersonde nach einem der Ansprüche 2 bis 11,
**dadurch gekennzeichnet,**
**dass** der Induktor (14, 16) oder die Induktoren (14, 16) jeweils durch elastische Elemente (20, 21, 46, 47), welche auf den jeweiligen Induktor (14, 16) aufgeschoben sind, in dem dem jeweiligen Induktor (14, 16) zugeordneten Induktorhalter (18, 44) gehalten ist bzw. sind.

13. Magnetometersonde nach einem der vorhergehenden Ansprüche,
**dadurch gekennzeichnet,**
**dass** der zweite Induktor (16) entsprechend dem schwenkbaren Induktor (14) durch eine elastische Lagerung im Sondengehäuse (12) schwenkbar gelagert und in seiner Schwenkposition arretierbar ist.

14. Magnetometersonde nach Anspruch 13,
**dadurch gekennzeichnet,**
**dass** die elastische Lagerung des zweiten Induktors (16) entsprechend einem der Ansprüche 3 bis 6 und, sofern vorgesehen, die Justiervorrichtung des zweiten Induktors (16) entsprechend einem der Ansprüche 7 bis 9 ausgebildet ist.

15. Magnetometersonde nach einem der Anprüche 1 bis 14,
**dadurch gekennzeichnet,**
**dass** das Sondengehäuse (12) nach außen hin fluiddicht abgedichtet ist.

16. Magnetometersonde nach Anspruch 15,
**dadurch gekennzeichnet,**
**dass** zum Abdichten des Sondengehäuses (12) an diesem Verschlusskappen (50) vorgesehen sind, die die beiden offenen Enden, in die die Induktoren (14, 16) eingesetzt sind, verschließen.
